# EUROPEAN PATENT APPLICATION

(11) **EP 1 583 409 A2**
(43) Date of publication of application: **05.10.2005**
(21) Application number: 05251694.5
(22) Date of filing: 19.03.2005
(51) Int. Cl.: H05K 7/14, H01R 13/74

(54) **Electrical apparatus and connections**

(30) Priority: 27.03.2004 GB 0406961
(71) Applicant: Smiths Group plc, London, NW11 8DS (GB)
(72) Inventor: Dent, Peter, Enfield Middlesex EN1 2RE (GB)
(74) Representative: Flint, Jonathan McNeill

(57) **Abstract**

An electronics housing 1 for a vehicle has several rectangular connectors 3 to 6 mounted on an end face 2. The housing 1 is received on a mounting tray 10 having a panel 11 at one end supporting cooperating connectors 13 to 16. A raised lip 101 on each side of the tray guides the housing 1 as it is slid along the tray to mate the connectors 3 to 6 on the housing as a push fit with one side of the connectors 13 to 16 on the panel 11. The other side of the connectors 13 to 16 on the panel 11 connect with cables 23 to 26 extending to remote locations in the vehicle. A locking mechanism 102 on the tray 10 retains the electronics housing 1 on the tray 10 when the connectors are mated.

## Description

This invention relates to electrical apparatus of the kind including a housing containing electrical circuits.

Military land vehicles carry increasing amounts of electronic equipment. This equipment has to be robust and reliable. Manufacturers are now finding it difficult to fit all the necessary equipment into the space available. Another significant problem is in making electrical connection to the housings containing the electronic units. Conventionally, the electrical housings are secured by means of bolts or the like to the vehicle chassis or other fixed structure and connection to the electrical housings is made by means of circular connectors, which are joined with the connectors on the housings after the housings have been secured in the vehicle. The two parts of the connector are push fitted together and retained by means of a locking ring that is twisted through about 90° to lock the two parts together. Whilst such connectors can be reliable, they do not allow for a high density of interconnection on the face of the housing because of the need to leave space around the connectors for the installer to be able to grip and twist mating connectors. They can also be very difficult to connect in confined spaces because of the need to grip the locking ring in order to complete the connection. The need to allow space for the installer to be able to grip the connector with his hand can be a severe problem to vehicle manufacturers.

It is an object of the present invention to provide alternative electrical apparatus and connections.

According to the present invention there is provided electrical apparatus of the above-specified kind, characterised in that the housing has a face supporting a plurality of first electrical connectors of rectangular, push-fit construction, that the connection unit includes a panel supporting a plurality of second connectors, that the second connectors have on one side of the panel a rectangular configuration arranged to mate with the first connectors on the housing, and that the second connectors, are configured on the other side of the panel to be connected with a cable.

The panel may be mounted at one end of a tray member, the tray member having a base plate on which the housing is supported. The base plate preferably has a raised lip extending along opposite edges between which the housing is guided. The connection unit may have a locking mechanism for retaining the housing in position on the connection unit with the connectors on the housing in mating contact with the connectors on the panel. The locking mechanism is preferably located on the connection unit at an end opposite the panel. The face of the housing is preferably of an electrically conductive material, the face supporting an electrical connector that makes electrical connection with the face, and the panel supporting a mating electrical connector such that the face of the housing is electrically connected with the panel via the connectors.

Electrical apparatus for a land vehicle will now be described, by way of example, with reference to the accompanying drawings, in which:
- Figure 1: is a perspective view of an electronics housing;
- Figure 2: is a perspective view of the outside of the connector face of the housing to a larger scale;
- Figure 3: is a perspective view of the inside of the connector face of Figure 2;
- Figure 4: is a perspective view of a connection tray on which the housing of Figure 1 is to be mounted;
- Figure 5: is a perspective view of one side of a panel forming a part of the connection tray;
- Figure 6: is a perspective view of the other side of the panel of Figure 5;
- Figure 7: is a perspective view showing how connectors are mounted on the panel; and
- Figure 8: is a perspective view of the connector in Figure 7 with its backshell separated from the connector.

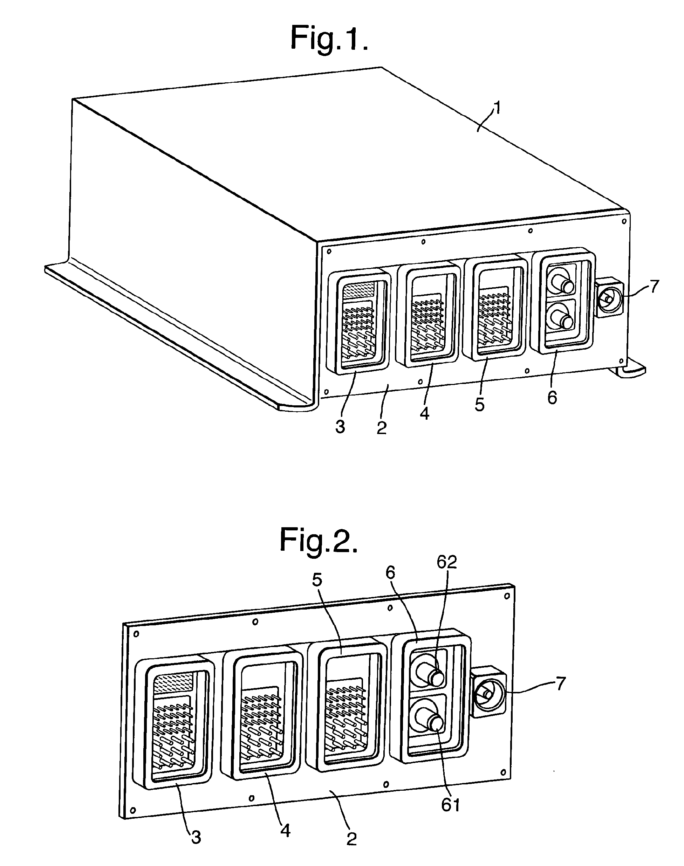

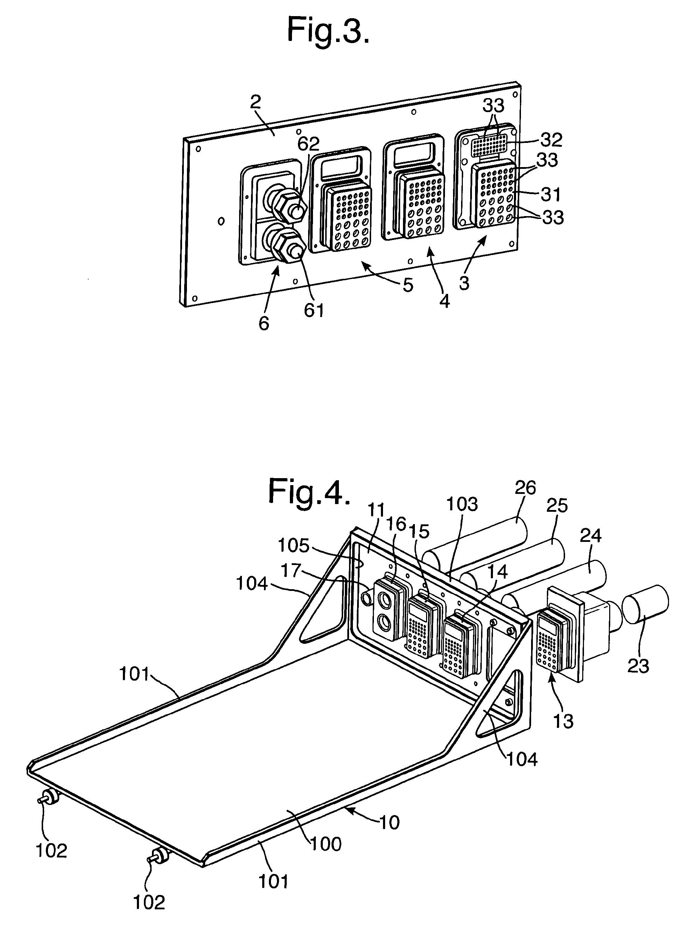

Figure 1 shows an equipment module or electronics housing 1 containing various electrical circuits and components and being of rectangular shape with a forward end face 2 supporting five electrical connectors 3 to 7. The housing 1 is installed in a military land vehicle (not shown) by means of a mounting tray 10 shown in Figure 4. The tray 10 supports a metal panel 11 at one end, which carries five electrical connector units 13 to 17. On one side of the panel 11, the connector units 13 to 17 are configured to mate with the connectors 3 to 7 on the equipment module 1. On the opposite side of the panel 11 the connector units 13 to 16 are connected to the ends of cables 23 to 26. The remaining connector unit 17 is for grounding purposes and is electrically connected with the panel 11 itself.

With reference now also to Figures 2 and 3, it can be seen that four of the connectors 3 to 6 on the end face 2 are of rectangular configuration. The remaining connector 7 is a size 4 ground contact pin connected directly with the end face 2 itself, which is of a metal or other electrically-conductive material. The left-hand connector 3 has two moulded insulating plastics inserts 31 and 32 each supporting multiple electrical contact elements 33 arranged in rows and columns. The larger, lower insert 31 has contacts of two different sizes, namely twelve size 12 contacts (23A) and twenty-four size 20 contacts (7.5A). The smaller, upper insert 32 supports forty size 22 contacts (5A). The adjacent two connectors 4 and 5 are similar with multiple contacts supported in plastics inserts. The fourth connector 6 supports two high current (250A) contacts 61 and 62 of size 00, one above the other. The contact elements 33 take the form of pins projecting forwardly of the front face 2 of the module 1, as shown in Figure 2. It can be seen that a relatively high number of electrical contacts of varying sizes can be supported on the end face 2 of the module 1.

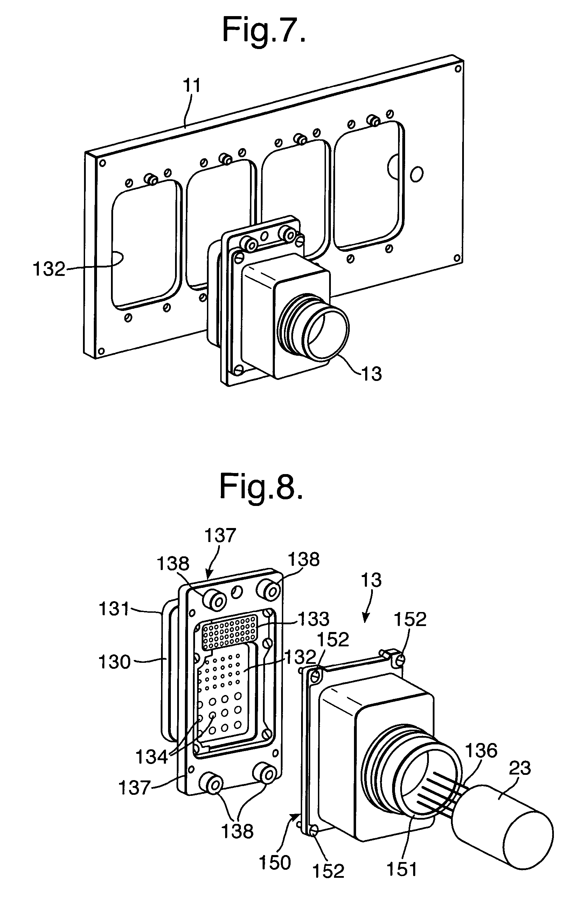

With reference now to Figures 4 to 8, the mounting tray 10 comprises a flat, metal base plate 100 with a shallow lip 101 projecting upwardly along each side. The dimensions of the plate 100 are such that the equipment module 1 can be slid onto and supported by the plate, guided between the two lips 101. At its rear end, two locking mechanisms 102 are attached with the plate 100. These comprise a threaded rod and a screw and cooperate with formations (not shown) at the rear of the underside of the module 1 so as to hold this in place on the tray 10. A rectangular support frame 103 projects vertically upwardly from the forward end of the tray 10 and is braced at each side by an open, triangular buttress 104 formed integrally with the base plate 100 and the frame 103. The panel 11 is attached with the support frame 103, the panel extending over a rectangular aperture 105 in the frame.

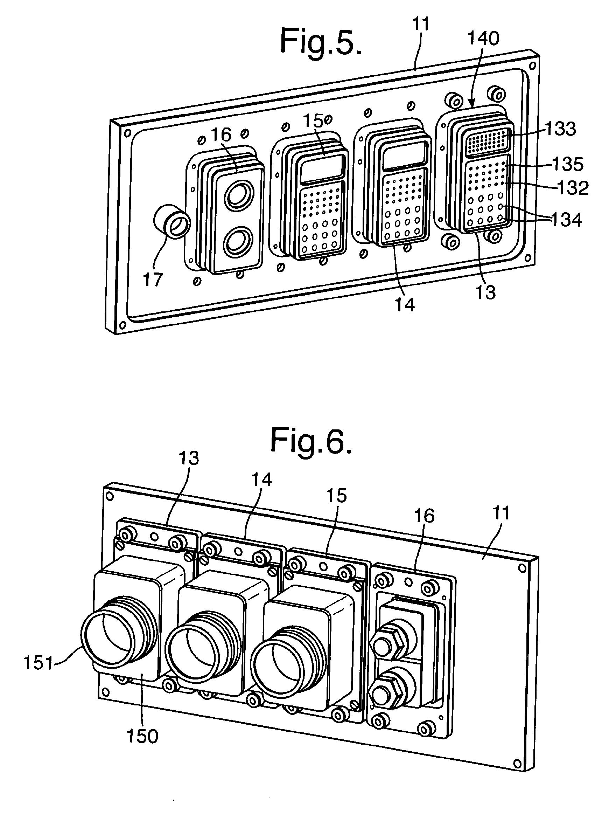

The connector units 13 to 16 are shown in most detail in Figures 5 to 8. The unit 13 will be described in detail although it will be appreciated that the other connector units 14 to 16 are similar. The connector unit 13 has an outer metal shell 130 of rectangular shape having a rear portion 131 that projects through a rectangular aperture 132 in the panel 11. Sealing and electrical connection of the shell 130 with the panel 11 is achieved by means of a peripheral seal and EMI band 140 (Figure 5). The shell 130 supports two insulative inserts 132 and 133, which in turn support a number of electrical contact elements 134 arranged in rows corresponding to the contact elements 33 in the connector 3 on the module 1. In particular, the contact elements 134 take the form of sockets exposed on the rear face 135 of the inserts 132 and 133 and into which the contacts elements 33 in the connector 3 can be inserted. At the forward end 135 of the inserts 132 and 133 individual wires 136 from the cable 23 are connected with respective ones of the sockets 134. This may be achieved in various different ways such as crimp connection, a solder connection or a push-fit connection where the socket is double-ended. A rectangular flange 137 projects outwardly around the shell 130 and supports four fixing screws 138 positioned to be screw threaded into tapped holes in the panel 11 so that the connector unit 13 can be supported on the panel. A rectangular backshell 150 with a circular cable port 151 is secured to the flange 137 by means of screws 152 and encloses the end of the cable 23 including the screen termination and insulation. The backshell 150 preferably also includes some provision for cable strain relief, such as some form of clamp that engages the outside of the cable. The cables 23 to 26 may form a part of a common cabling loom.

The connector units 13 to 16 can be fitted to the end of the respective cables 23 to 26 before the connector units are secured to the panel 11. Once the connector units 13 to 16 have been installed in the panel 11 and the panel has been mounted on the tray 10, the equipment module 1 can be slid along the tray from its rear end, being guided by the lips 101 along each edge. The connectors 3 to 7 on the module 1 are mated with the connectors 13 to 17 on the tray 10 simply as a push fit, the module then being locked in place, with the connectors mated, by the locking mechanism 102.

This arrangement can be used to enable a large number of connections to be made to a single face of an electronics housing. The connectors can be installed on the cables in the factory whereas the electronics housings can readily be connected with the connectors on the tray simply by pushing the housing into position. The cable-mounted connectors can be installed in relatively inaccessible locations so that maximum use can be made of the available space.

## Claims

1. Electrical apparatus including a housing (1) containing electrical circuits, and a connection unit (10) secured with a vehicle structure, **characterised in that** the housing (1) has a face (2) supporting a plurality of first electrical connectors (3, 4, 5, 6) of rectangular, push-fit construction, that the connection unit (10) includes a panel (11) supporting a plurality of second connectors (13, 14, 15, 16), that the second connectors have on one side of the panel a rectangular configuration arranged to mate with the first connectors (3, 4, 5, 6) on the housing (1), and that the second connectors (13, 14, 15, 16), are configured on the other side of the panel (11) to be connected with a cable (23, 24, 25, 26).

2. Electrical apparatus according to Claim 1, **characterised in that** the panel (11) is mounted at one end of a tray member (10) and that the tray member has a base plate (100) on which the housing (1) is supported.

3. Electrical apparatus according the Claim 2, **characterised in that** the base plate (100) has a raised lip (101) extending along opposite edges between which the housing (1) is guided.

4. Electrical apparatus according to any one of the preceding claims, **characterised in that** the connection unit (10) has a locking mechanism (102) for retaining the housing in position on the connection unit (10) with the connectors (3, 4, 5, 6) on the housing (1) in mating contact with the connectors (13, 14, 15, 16) on the panel (11).

5. Electrical apparatus according to Claim 4, **characterised in that** the locking mechanism is located on the connection unit (10) at an end opposite the panel (11).

6. Electrical apparatus according to any one of the preceding claims, **characterised in that** the face (2) of the housing (1) is of an electrically conductive material, that the face supports an electrical connector (7) that makes electrical connection with the face, and that the panel (11) supports a mating electrical connector (17) such that the face (2) of the housing (1) is electrically connected with the panel (11) via the connectors (7 and 17).
